# EUROPÄISCHE PATENTANMELDUNG

(11) **EP 0 590 628 A1**
(43) Veröffentlichungstag der Anmeldung: **06.04.1994**
(21) Anmeldenummer: 93115700.2
(22) Anmeldetag: 28.09.1993
(51) Int. Cl.: H05K 3/34, H05K 1/11

(54) **Verfahren zum Beloten einer Leiterplatte mit Bauelementen und Leiterplatte**

(30) Priorität: 29.09.1992 DE 4232634
(71) Anmelder: SIEMENS AKTIENGESELLSCHAFT, D-80333 München (DE)
(72) Erfinder: Bootz, Eric, Dipl.-Ing., D-93309 Kelheim (DE); Maiwald, Werner, Dipl.-Phys., D-83043 Bad Aibling (DE)

(57) **Zusammenfassung**

Beim Beloten einer Leiterplatte mit Bauelementen, bei dem eine Lotpaste auf elektrisch leitfähige Anschlußflächen der Leiterplatte aufgetragen wird, die nach dem Bestücken der Leiterplatte mit Anschlüssen der Bauelemente verlötet wird, ist vorgesehen, daß Lotpastenflecken (2) zueinander versetzte auf partielle Endereiche der Anschlußflächen (1) aufgetragen wird, die gegenüber den restlichen Bereichen verjüngt sind. Es gelingt so, Bauelemente auch bei feinsten Lötrastern mit Rastermaßen unter 0,5 mm sicher und zuverlässig zu verlöten.

## Beschreibung

Die Erfindung betrifft ein Verfahren zum Beloten einer Leiterplatte mit Bauelementen, bei dem eine Lotpaste auf elektrisch leitfähige Anschlußflächen der Leiterplatte aufgetragen wird, die nach dem Bestücken der Leiterplatte mit Anschlüssen der Bauelemente verlötet werden.

Bei der Fertigung elektronischer Baugruppen hat die Oberflächenmontierung von Bauelementen gegenüber der Kontaktlochmontierung von Bauelementen eine wesentliche Bedeutung erlangt. Die höhere Packungsdichte oberflächenmontierter Bauelemente (SMC, Service Mount Components) auf gedruckten Leiterplatten (PCB, Printed Circuit Boards) erfordert reduzierte Abstände zwischen den Bauelementen sowie kleinere Abmessungen der Lötpunkte und deshalb eine höhere Anzahl von Lötpunkten auf jeder Leiterplatte. Daraus und durch die schwierigere Leiterplattenkontrolle ergibt sich ein Zwang zu einem möglichst perfekten Verlöten der Bauelemente. Ausbeuten unter 95 % können in einer guten Fertigung nicht mehr akzeptiert werden. Eine zusätzliche Rahmenbedingung ergibt sich aus der Forderung nach möglichst günstigen Herstellungskosten.

Eine gegenwärtig weit verbreitete Technik bei der Verarbeitung hochpoliger integrierter Schaltkreise ist die Lotpastentechnik. Dabei wird auf elektrisch leitfähige Anschlußflächen (Lötpads) mit Hilfe von Druck- oder Dosierverfahren Lotpaste aufgebracht, die flächenförmige Lotdepots bildet. Nach dem Bestücken der Bauelemente auf die mit den Lotdepots bedruckte Leiterplatte wird diese dann im Reflow-Verfahren relativ langsam bis über den Schmelzpunkt der jeweiligen Lotlegierung erwärmt und so durch Aufschmelzen der Lotpaste die Lötverbindung hergestellt. Bei der Optimierung des Verfahrens kommt es darauf an, daß beim Aufschmelzen der Lotpaste kein Kurzschluß zwischen den Anschlüssen des Bauelements oder eine Unterbrechung durch ungenügende Lötung erfolgen kann. Bereits ein schlecht verlöteter Anschluß des Bauelements kann zum Ausfall des Bausteins auf der Platine führen.

Beispiele für den Lotpastenauftrag sind aus Siemens-Datenbuch, Halbleiter-Gehäsue-Information, 1991, S. 147 bekannt.

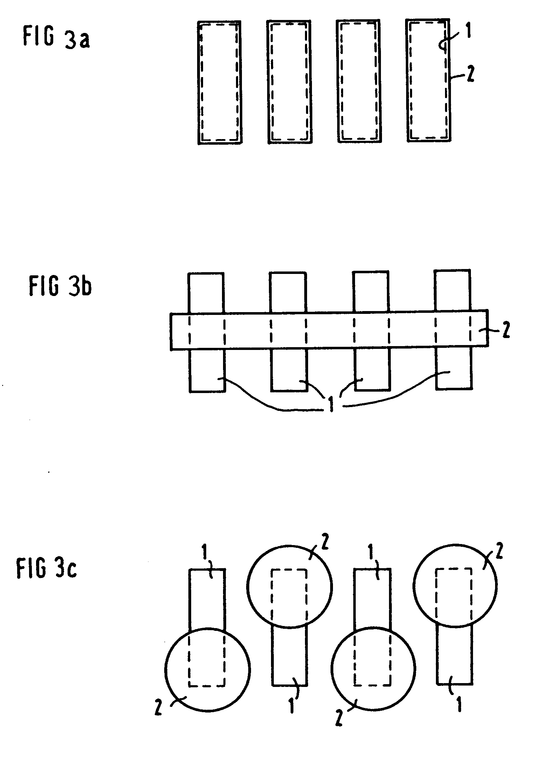

Bisher wird die Lotpaste 2 etwa deckungsgleich auf die darunterliegende fingerförmige oder rechteckige elektrisch leitfähige Anschlußfläche 1 (Lötpad) oder in quer über die Anschlußflächen verlaufenden Streifen aufgetragen, Figur 3 a), 3 b). Insbesondere bei quer über die Anschlußflächen aufgetragenen Lotpastenstreifen (Figur 3b) besteht die Gefahr, daß sich beim Aufschmelzen der Lotpaste Lotperlen bilden, die zum Kurzschluß zwischen den Anschlußflächen bzw. den Anschlüssen des Bauelements führen können.

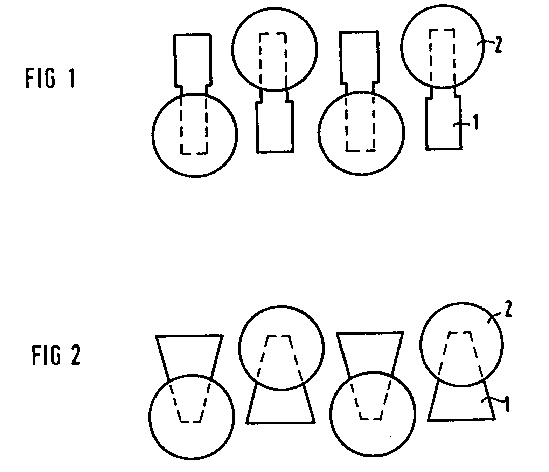

Eine andere Möglichkeit bietet der versetzte Lotpastenauftrag. Dabei sind rechteckförmige Anschlußflächen 1 vorgesehen, die so nebeneinander angeordnet sind, daß ihre Längsrichtungen parallel liegen, Fig. 3c. Der Auftrag von Lotpaste 2 erfolgt mit Hilfe bekannter Druck- oder Dosierverfahren in zueinander versetzter Form auf abwechselnd entgegengesetzte Endbereiche der Anschlußflächen. Dabei kann die Lotpaste geringfügig über den Endbereich der Anschlußfläche hinausgehen und einen Teil der Zwischenräume zu den benachbarten Anschlußflächen bzw. in Längsrichtung der Anschlußfläche abdecken. Durch den gegeneinander versetzten Lotauftrag auf partielle Bereiche der Anschlußflächen läßt sich der Rasterabstand gegenüber herkömmlicher Lotpastentechnik verringern und deshalb der Lotpastendruck auch für Rastermaße bis 0,5 mm anwenden. Bei der Anordnung gemäß Figur 1 ist für den nachfolgenden Lotvorgang ein speziell ausgesuchtes bzw. angepaßtes Fließmittel erforderlich, das ein Verfließen eines Lotpastenfleckens 2 auf die gesamte Anschlußfläche 1 ermöglicht.

Die bekannte Lotpastentechnik erreicht deshalb ihre Grenze heute bei Bauelementen mit einem Anschlußraster von etwa 0,5 mm, wobei allerdings die Ausbeute vielfach nicht ausreichend ist.

Aus der JP-A-4-71290 ist bekannt, Lotpaste auf die breiteren Enden trapezförmiger, nebeneinander liegender Anschlußflächen zu geben. Dies führt jedoch nicht zu Lötverbindungen im Fine-Pitch-Bereich mit der geforderten Ausbeute.

Der Erfindung liegt die Aufgabe zugrunde, ein Verfahren zum Beloten einer Leiterplatte und eine Leiterplatte anzugeben, die sich für das zuverlässige Verlöten mit Bauelementen mit geringerem Anschlußraster als 0,5 mm eignen.

Diese Aufgabe wird mit den Merkmalen der Patentansprüche 1 und 3 gelöst.

Die Erfindung hat den Vorteil, daß sie ohne Änderung der beim Löten verwendeten Materialien eine wesentlich höhere hohe Auflösung ermöglicht.

Ausgestaltungen der Erfindung sind in Unteransprüchen gekennzeichnet.

Die Erfindung wird nachfolgend anhand von Ausführungsbeispielen beschrieben. Es zeigen:
- Figuren 1 bis 2: unterschiedliche Anschlußflächen von Leiterplatten mit aufgetragener Lotpaste
und
- Figur 3: bekannte Anordnungen von Lotpaste und Anschlußfläche.

Die Erfindung beruht auf der Erkenntnis, daß die Benetzungskraft der Anschlußflächen für den Lötvorgang genutzt und die Oberflächenspannung der Lotpaste gezielt zum Verfließen der Lotpaste eingesetzt werden kann. Beim physikalischen Effekt der dadurch gegebenen Lotwanderung werden die Bauelement-Anschlüsse sicher und zuverlässig benetzt.

Figuren 1 und 2 zeigen Anordnungen von Anschlußflächen und Lotpastenflecken, die auch bei nicht speziell ausgewähltem Fließmittel ein gutes Verfließen der Lotpaste beim Reflow-Vorgang ermöglichen. Dabei werden Lotpastenflecken zueinander versetzt auf partielle Endbereiche der Anschlußflächen aufgetragen, die gegenüber den restlichen Bereichen der jeweiligen Anschlußflächen verjüngt sind. In der Anordnung nach Figur 1 weisen die Längsseiten der Anschlußflächen 1 einen Knick bzw. eine Stufe auf, gemäß Figur 2 sind die Anschlußflächen trapezförmig oder konisch geformt. Nach dem Aufbringen von Fließmittel und dem Bestücken mit Bauelementen hat beim Reflow-Prozeß das schmelzende Lot wegen der Benetzungskraft der Anschlußflächen und der Oberflächenspannung der Lotpaste bzw. des Lötzinns die Tendenz, von der schmaleren Anschlußfläche auf die breitere Anschlußfläche zu fließen. Dabei muß die Lotpaste zwangsläufig die nicht dargestellten Anschlüsse des Bauelements umfließen, so daß eine sichere und zuverlässige Lötverbindung zustande kommt.

## Patentansprüche

1. Verfahren zum Beloten einer Leiterplatte mit Bauelementen, bei dem eine Lotpaste auf elektrisch leitfähige Anschlußflächen der Leiterplatte aufgetragen wird, die nach dem Bestücken der Leiterplatte mit Anschlüssen der Bauelemente verlötet werden, wobei die Lotpaste partiell auf gegenüberliegende Endbereiche benachbarter Anschlußflächen und über die für den Auftrag vorgesehenen partiellen Bereiche der Anschlußflächen hinaus auf benachbarte Bereiche der Leiterplatte aufgetragen wird,
**dadurch gekennzeichnet,**
daß die Lotpaste (2) auf partielle Endbereiche der Anschlußflächen aufgetragen wird, die gegenüber den restlichen Bereichen der Anschlußflächen verjüngt sind.

2. Verfahren nach Anspruch 1 ,
**dadurch gekennzeichnet,**
daß der Lotauftrag mittels Sieb- oder Schablonendruck erfolgt.

3. Leiterplatte mit elektrisch leitfähigen nebeneinander angeordneten Anschlußflächen, deren abwechselnd entgegengesetzte Endbereiche verjüngt sind,
**dadurch gekennzeichnet,**
daß sich die verjüngten Bereiche stufenförmig von den breiteren Anschlußbereichen absetzen.
